# EUROPEAN PATENT SPECIFICATION

(11) **EP 3 131 118 B1**
(45) Date of publication and mention of the grant of the patent: **17.04.2019**
(21) Application number: 16173492.6
(22) Date of filing: 08.06.2016
(51) Int. Cl.: H01L 23/528, H01L 23/522, H01L 23/532

(54) **SEMICONDUCTOR DEVICE ALLOWING METAL LAYER ROUTING FORMED DIRECTLY UNDER METAL PAD**
HALBLEITERBAUELEMENT MIT ZULASSUNG DER FÜHRUNG EINER UNMITTELBAR UNTER EINEM METALLKISSEN GEFORMTEN METALLSCHICHT
DISPOSITIF À SEMI-CONDUCTEUR PERMETTANT LE ROUTAGE DE COUCHE MÉTALLIQUE SITUÉE DIRECTEMENT SOUS LE PATIN MÉTALLIQUE

(30) Priority: 12.08.2015 US 201562204160 P; 26.05.2016 US 201615164889
(43) Date of publication of application: 15.02.2017
(73) Proprietor: MediaTek Inc., Hsin-Chu 300 (TW)
(72) Inventor: CHEN, Chun-Liang, Hsinchu County 302 (TW)
(74) Representative: Hoefer & Partner Patentanwälte mbB

(56) References cited:
- WO-A1-2008/015500
- WO-A1-2009/058143
- WO-A1-2015/102753
- WO-A2-03/079437
- US-A1- 2014 217 601

## Description

The disclosed embodiments of the present invention relate to a semiconductor device, and more particularly, to a semiconductor device which can allow a metal layer routing formed directly under a metal pad according to the pre-characterizing clauses of claim 1.

Conventionally, a power line and a ground line comprised in a semiconductor device cannot be formed under a mutual metal pad which results in a large layout area consumed for the power line and the ground line.

The relevant features of the document WO 2009/058143 A1 are included in the preamble portion of the independent claim of the present application.

The document WO 03/079437 A2 discloses that a bond pad has a probe region and a wire bond region that are substantially non-overlapping. In one embodiment, the bond pad is connected to a final metal layer pad and extends over an interconnect region. The bond pad is formed from aluminum and the final metal layer pad is formed from copper. Separating the probe region from the wire bond region prevents the final metal layer pad from being damaged by probe testing, allowing for more reliable wire bonds. In another embodiment, the probe region extends over a passivation layer. In an application requiring very fine pitch between bond pads, the probe regions and wire bond regions of a plurality of bond pads formed in a line may be staggered to increase the distance between the probe regions. In addition, forming the bond pads over the interconnect region reduces the size of the integrated circuit.

The document WO 2008/015500 A1 discloses a method of securing a bond pad in to a semiconductor chip having an upper top metal surface which includes one or more holes, the method comprising the steps of forming a passivation layer over the upper metal surface, which passivation layer has holes therein substantially corresponding to the or each hole in the upper metal layer and being substantially the same size or smaller than the holes in the upper metal layer; forming the bond pad over the passivation layer; characterized in that the step of forming the bond pad comprises introducing some of the material from the bond pad into the holes in the passivation layer and upper metal layer when forming the bond pad, securing the bond pad to the passivation layer by allowing said material to flow under the surface thereof and attach thereto without attaching to the upper metal layer to thereby form a securing means.

In accordance with exemplary embodiments of the present invention, a semiconductor device as recited in claim 1 is proposed to solve the above-mentioned problem. According to an aspect of the present invention, an exemplary semiconductor device is disclosed. The semiconductor device comprises: a metal pad and a first specific metal layer routing. The metal pad is positioned in a first metal layer of the semiconductor device. The first specific metal layer routing is formed in a second metal layer of the semiconductor device, and directly under the metal pad.

According to an aspect of the present invention, an exemplary semiconductor device is disclosed. The semiconductor device may comprise a metal pad and a first specific metal layer routing. The metal pad is positioned in a first metal layer of the semiconductor device and is directly contacting the first metal layer. The first specific metal layer routing is formed in a second metal layer of the semiconductor device and under the metal pad. In addition, the semiconductor device may comprise at least one via plug (e.g. one or more via plugs, such as a plurality of via plugs) for connecting the first specific metal layer routing to at least one metal region (e.g. one or more metal regions) in the first metal layer, where the aforementioned at least one via plug is formed directly under the metal pad.

Briefly summarized, compared with prior art, since the semiconductor device disclosed by the present invention can allow a metal layer routing formed directly under a metal pad, the layout area size of the semiconductor device can be reduced effectively.

In the following, the invention is further illustrated by way of example, taking reference to the accompanying drawings . Thereof
FIG. 1 is a simplified top-view diagram of a conventional semiconductor device,
FIG. 2 is a simplified cross-sectional diagram of a semiconductor device according to a first exemplary embodiment of the present invention,
FIG. 3 is a simplified top-view diagram of the semiconductor device in FIG. 2,
FIG. 4 is a simplified cross-sectional diagram of a semiconductor device according to a second exemplary embodiment of the present invention,
FIG. 5 is a simplified top-view diagram of the semiconductor device in FIG. 4,
FIG. 6 is a simplified cross-sectional diagram of a semiconductor device according to a third exemplary embodiment of the present invention,
FIG. 7 is a simplified top-view diagram of the semiconductor device in FIG. 6, and
FIG. 8 is a simplified top-view diagram of a semiconductor device according to a fourth exemplary embodiment of the present invention.

Certain terms are used throughout the description and following claims to refer to particular components. As one skilled in the art will appreciate, manufacturers may refer to a component by different names. This document does not intend to distinguish between components that differ in name but not function. In the following description and in the claims, the terms "include" and "comprise" are used in an open-ended fashion, and thus should be interpreted to mean "include, but not limited to ...".

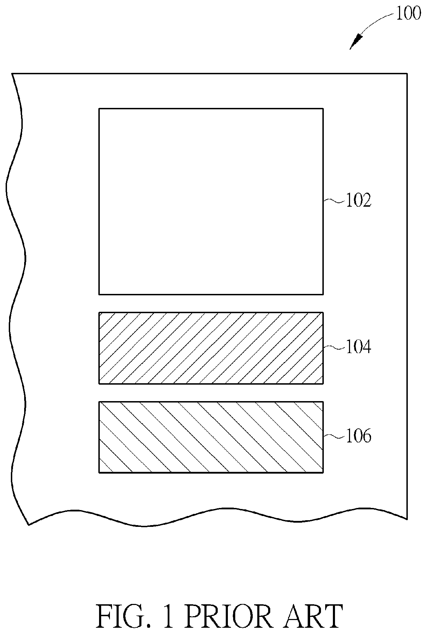

Please refer to FIG. 1 which is a simplified top-view diagram of a conventional semiconductor device 100, wherein the semiconductor device 100 can be a chip. As shown in FIG. 1, the semiconductor device 100 comprises: a metal pad 102, a power line 104, and a ground line 106. However, the power line 104 and a ground line 106 cannot be formed under the metal pad 102, and thus the semiconductor device 100 has a problem of requiring a large layout area for the power line 104 and a ground line 106.

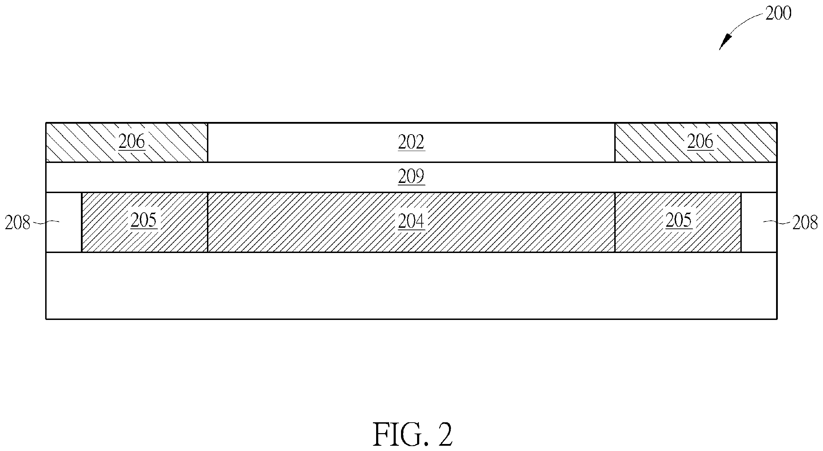

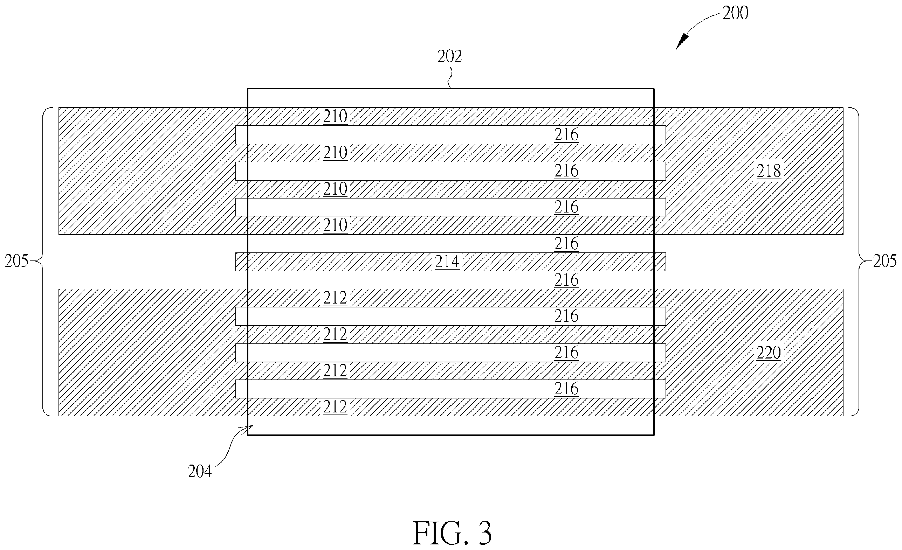

Please refer to FIG. 2 and FIG. 3. FIG. 2 is a simplified cross-sectional diagram of a semiconductor device 200 according to a first exemplary embodiment of the present invention, and FIG. 3 is a simplified top-view diagram of the semiconductor device 200, where the semiconductor device 200 can be a chip. As shown in FIG. 2 and FIG. 3, the semiconductor device 200 may comprise a metal pad 202, a first specific metal layer routing 204, and a second specific metal layer routing 205. The metal pad 202 is positioned in a first metal layer 206 of the semiconductor device 200, where the metal pad 202 has a thickness smaller than 20KA (i.e. 2 micrometers), and material of the metal pad 202 can be aluminum. The first specific metal layer routing 204 is formed in a second metal layer 208 of the semiconductor device 200, and directly under the metal pad 202. As shown in FIG. 2, the metal pad 202 may be regarded as a portion of the first metal layer 206, and the first specific metal layer routing 204 and the second specific metal layer routing 205 may be regarded as some portions of the second metal layer 208. In addition, please note that the above embodiment is only for an illustrative purpose and is not meant to be a limitation of the present invention. For example, the architecture shown in FIG. 2 can be changed according to different design requirements.

The first specific metal layer routing 204 has a uniform pattern, where the uniform pattern has a metal density range between 30% and 70%. Please note that if the metal density of the uniform pattern is higher than 70%, the first specific metal layer routing 204 under the metal pad 202 will fail. If the metal density of the uniform pattern is lower than 30%, it will be hard to design the first specific metal layer routing 204 under the metal pad 202. As shown in FIG. 3, the first specific metal layer routing 204 may comprise four first power lines 210, four first ground lines 212, and at least one unused metal line (e.g. one or more unused metal lines) such as the unused metal line 214 of this embodiment, where there are oxide regions 216 between the first power lines 210, the first ground lines 212, and the unused metal line 214, and each oxide region 216 can have a width greater than 2 micrometers. In addition, the unused metal line 214 is kept as a dummy pattern for robust bondability. The second specific metal layer routing 205 is formed in the second metal layer 208 of the semiconductor device 200 and connected to the first specific metal layer routing 204, where the second specific metal layer routing 205 is not positioned under the metal pad 202. The second specific metal layer routing 205 may comprise a second power line 218 and a second ground line 220. Please note that the first metal layer 206 and the second metal layer 208 are adjacent metal layers of the semiconductor device 200, and there is an oxide layer 209 between the first metal layer 206 and the second metal layer 208. In addition, please note that the above embodiment is only for an illustrative purpose and is not meant to be a limitation of the present invention. For example, the numbers of the first power lines 210, the first ground lines 212, and the unused metal line 214 can be changed according to different design requirements, respectively.

Briefly summarized, compared with prior art, since the semiconductor device disclosed by the present invention can allow the metal layer routing formed directly under the metal pad, the layout area size of the semiconductor device can be reduced effectively.

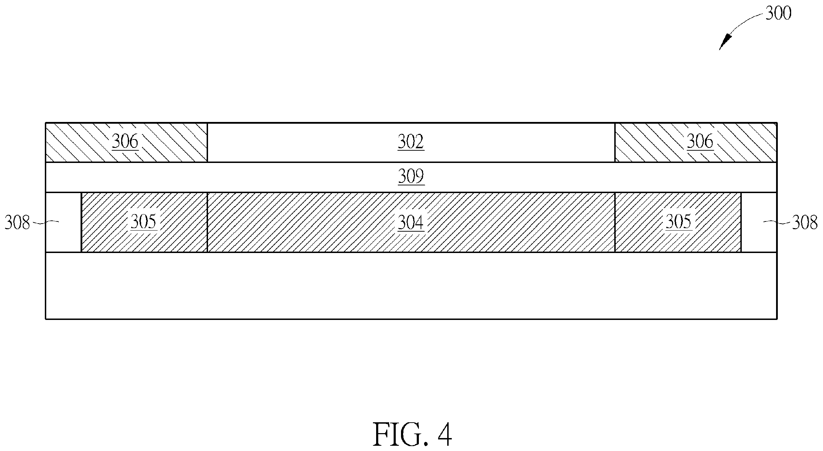

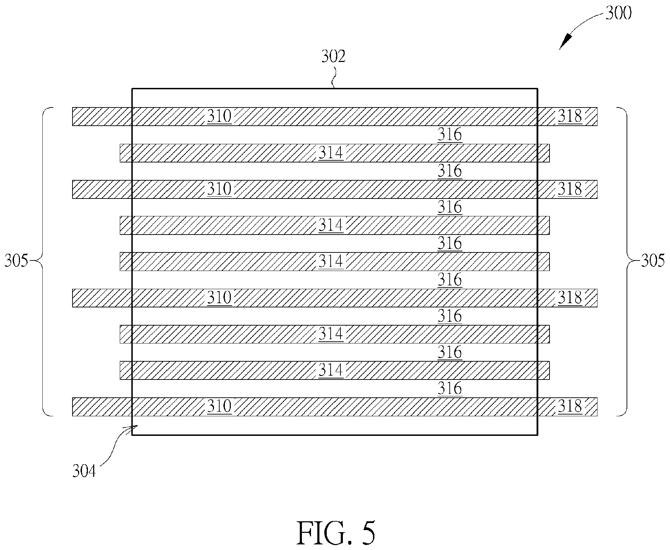

Please refer to FIG. 4 and FIG. 5. FIG. 4 is a simplified cross-sectional diagram of a semiconductor device 300 according to a second exemplary embodiment of the present invention, and FIG. 5 is a simplified top-view diagram of the semiconductor device 300, where the semiconductor device 300 can be a chip. As shown in FIG. 4 and FIG. 5, the semiconductor device 300 may comprise a metal pad 302, a first specific metal layer routing 304, and a second specific metal layer routing 305. The metal pad 302 is positioned in a first metal layer 306 of the semiconductor device 300, where the metal pad 302 has a thickness smaller than 20KA (i.e. 2 micrometers), and material of the metal pad 302 can be aluminum. The first specific metal layer routing 304 is formed in a second metal layer 308 of the semiconductor device 300, and directly under the metal pad 302. As shown in FIG. 4, the metal pad 302 may be regarded as a portion of the first metal layer 306, and the first specific metal layer routing 304 and the second specific metal layer routing 305 may be regarded as some portions of the second metal layer 308. In addition, please note that the above embodiment is only for an illustrative purpose and is not meant to be a limitation of the present invention. For example, the architecture shown in FIG. 4 can be changed according to different design requirements.

The first specific metal layer routing 304 has a uniform pattern, where the uniform pattern has a metal density range between 30% and 70%. Please note that if the metal density of the uniform pattern is higher than 70%, the first specific metal layer routing 304 under the metal pad 302 will fail. If the metal density of the uniform pattern is lower than 30%, it will be hard to design the first specific metal layer routing 304 under the metal pad 302. As shown in FIG. 5, the first specific metal layer routing 304 may comprise four first IO routing lines 310 and five unused metal lines 314, where there are oxide regions 316 between the first IO routing lines 310 and the unused metal lines 314, and each oxide region 316 can have a width greater than 3 micrometers. In addition, the unused metal lines 314 are kept as a dummy pattern for robust bondability. The second specific metal layer routing 305 is formed in the second metal layer 308 of the semiconductor device 300 and connected to the first specific metal layer routing 304, where the second specific metal layer routing 305 is not positioned under the metal pad 302. The second specific metal layer routing 305 may comprise four second IO routing lines 318, where the semiconductor device 300 may comprise at least one via plug (e.g. one or more via plugs) for connecting at least one portion (e.g. a portion or all) of the second IO routing lines 318 to other metal line(s) in other metal layer(s), such as a plurality of via plugs for connecting the second IO routing lines 318 to some other metal lines in one or more other metal layers, respectively. Please note that the first metal layer 306 and the second metal layer 308 are adjacent metal layers of the semiconductor device 300, and there is an oxide layer 309 between the first metal layer 306 and the second metal layer 308. In addition, please note that the above embodiment is only for an illustrative purpose and is not meant to be a limitation of the present invention. For example, the numbers of the first IO routing lines 310 and the unused metal lines 314 can be changed according to different design requirements, respectively.

Briefly summarized, compared with prior art, since the semiconductor device disclosed by the present invention can allow the metal layer routing formed directly under the metal pad, the layout area size of the semiconductor device can be reduced effectively.

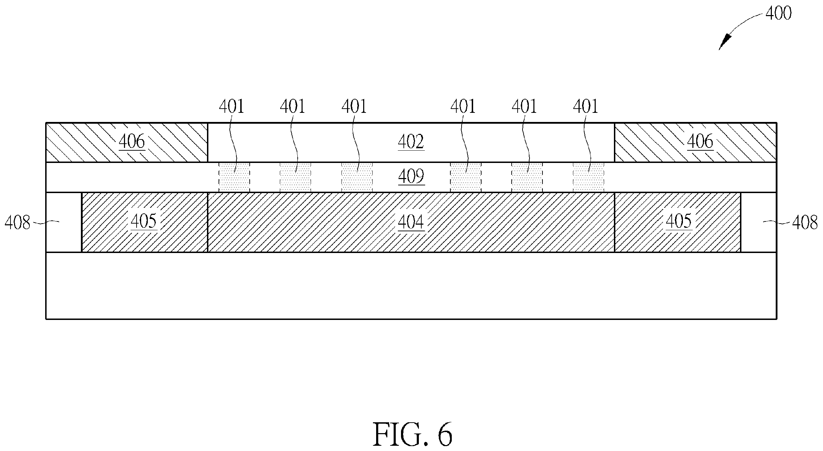

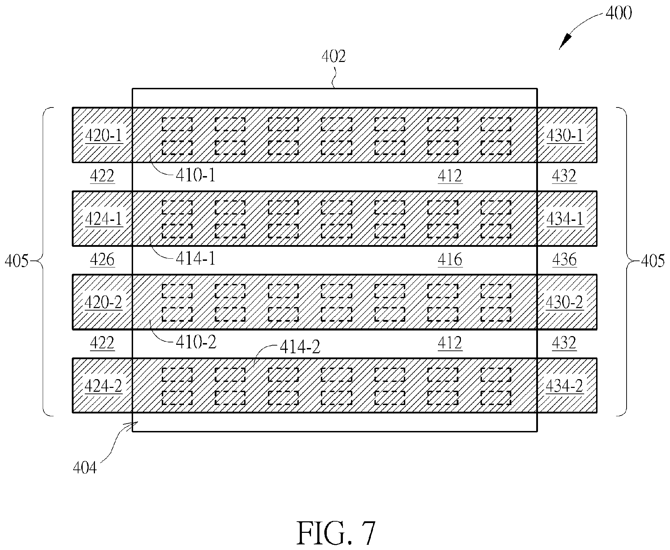

Please refer to FIG. 6 and FIG. 7. FIG. 6 is a simplified cross-sectional diagram of a semiconductor device 400 according to a third exemplary embodiment of the present invention, and FIG. 7 is a simplified top-view diagram of the semiconductor device 400, where the semiconductor device 400 can be a chip. As shown in FIG. 6 and FIG. 7, the semiconductor device 400 may comprise a metal pad 402, a first specific metal layer routing 404, and a second specific metal layer routing 405. The metal pad 402 is positioned in a first metal layer 406 of the semiconductor device 400, where the metal pad 402 has a thickness smaller than 20KA (i.e. 2 micrometers), and material of the metal pad 402 can be aluminum. The first specific metal layer routing 404 is formed in a second metal layer 408 of the semiconductor device 400 and under the metal pad 402. As shown in FIG. 6, the metal pad 402 may be regarded as a portion of the first metal layer 406, and the first specific metal layer routing 404 and the second specific metal layer routing 405 may be regarded as some portions of the second metal layer 408. In addition, the semiconductor device 400 may comprise at least one via plug (e.g. one or more via plugs) for connecting the first specific metal layer routing 404 to at least one metal region (e.g. one or more metal regions) in the first metal layer 406, where the aforementioned at least one via plug is formed directly under the metal pad 402. For example, the aforementioned at least one via plug may comprise multiple via plugs, such as a plurality of via plugs 401, directly under the metal pad 402, and the via plugs 401 may be utilized for connecting multiple portions of the first specific metal layer routing 404 to some metal regions in the first metal layer 406, respectively. Please note that the above embodiment is only for an illustrative purpose and is not meant to be a limitation of the present invention. For example, the architecture shown in FIG. 6 can be changed according to different design requirements. In some examples, the numbers of the via plugs 401 can be changed according to different design requirements.

The first specific metal layer routing 404 has a uniform pattern, where the uniform pattern has a metal density range between 30% and 70%. Please note that if the metal density of the uniform pattern is higher than 70%, the first specific metal layer routing 404 under the metal pad 402 will fail. If the metal density of the uniform pattern is lower than 30%, it will be hard to design the first specific metal layer routing 404 under the metal pad 402. As shown in FIG. 7, the first specific metal layer routing 404 may comprise a plurality of sets of terminal lines corresponding to terminals of a plurality of field effect transistors (FETs), respectively, such as the set of terminal lines {410-1, 414-1} and the set of terminal lines {410-2, 414-2}. For example, the terminal line 410-1 can be a source terminal line corresponding to the source terminal of a first FET within the plurality of FETs, and the terminal line 414-1 can be a drain terminal line corresponding to the drain terminal of the first FET. In addition, the terminal line 410-2 can be a source terminal line corresponding to the source terminal of a second FET within the plurality of FETs, and the terminal line 414-2 can be a drain terminal line corresponding to the drain terminal of the second FET. In some embodiments, the arrangement of the plurality of sets of terminal lines may vary. For example, the terminal line 414-1 can be a source terminal line corresponding to the source terminal of the first FET within the plurality of FETs, and the terminal line 410-1 can be a drain terminal line corresponding to the drain terminal of the first FET. In addition, the terminal line 414-2 can be a source terminal line corresponding to the source terminal of the second FET within the plurality of FETs, and the terminal line 410-2 can be a drain terminal line corresponding to the drain terminal of the second FET.

According to the embodiment shown in FIG. 7, the small boxes illustrated with dashed lines can be taken as examples of the via plugs 401, and the via plugs 401 may be positioned between the metal pad 402 and the plurality of sets of terminal lines (e.g. the set of terminal lines {410-1, 414-1} and the set of terminal lines {410-2, 414-2}). As shown in FIG. 7, there may be at least one oxide region (e.g. one or more oxide regions) between the plurality of sets of terminal lines, such as the oxide regions 416 between the set of terminal lines {410-1, 414-1} and the set of terminal lines {410-2, 414-2} in this embodiment, and each oxide region of the aforementioned at least one oxide region, such as the oxide region 416 has a width greater than 2 micrometers. For example, there is an oxide region 412 between the source terminal line and the drain terminal line of each set of the plurality of sets of terminal lines, and the oxide region 412 has a width greater than 2 micrometers. In addition, the second specific metal layer routing 405 is formed on the second metal layer 408 of the semiconductor device 400 and connected to the first specific metal layer routing 404, where the second specific metal layer routing 405 is not positioned under the metal pad 402. The second specific metal layer routing 405 may comprise a plurality of sets of terminal lines corresponding to the plurality of sets of terminal lines of the first specific metal layer routing 404, respectively. Examples of the plurality of sets of terminal lines of the second specific metal layer routing 405 may include, but not limited to, the set of terminal lines {420-1, 424-1}, the set of terminal lines {420-2, 424-2}, the set of terminal lines {430-1, 434-1}, and the set of terminal lines {430-2, 434-2}. In this embodiment, the plurality of sets of terminal lines of the second specific metal layer routing 405 may be regarded as extensions of the plurality of sets of terminal lines of the first specific metal layer routing 404, respectively, where the width of the terminal lines, the width of the gap between adjacent sets of terminal lines, and the width of the gap between the terminal lines in each set of terminal lines may be kept constant, no matter whether the terminal lines are under the metal pad 402 or not. Please note that the first metal layer 406 and the second metal layer 408 are adjacent metal layers of the semiconductor device 400, and there is an oxide layer 409 between the first metal layer 406 and the second metal layer 408. For example, the via plugs 401 may pass through the oxide layer 309. In addition, please note that the above embodiment is only for an illustrative purpose and is not meant to be a limitation of the present invention. For example, the numbers of sets of terminal lines can be changed according to different design requirements.

Briefly summarized, compared with prior art, since the semiconductor device disclosed by the present invention can allow the metal layer routing formed directly under the metal pad, the layout area size of the semiconductor device can be reduced effectively.

According to some embodiments, at least one size of at least one side of the aforementioned at least one via plug (e.g. one or more via plugs, such as the via plugs 401) is not less than 1 micrometer. For example, each of the via plugs 401 may be implemented to have a conduction area such as 1 micrometer by 1 micrometer, to allow currents to pass through the via plugs 401 (e.g. from the metal pad 402 to the first specific metal layer routing 404, or from the first specific metal layer routing 404 to the metal pad 402) without damaging the via plugs 401, and the number of via plugs within the via plugs 401 may be very great, to achieve a predetermined percentage of the area under the metal pad 402, where they may be widely and uniformly distributed, under the metal pad 402. This is only for an illustrative purpose and is not meant to be a limitation of the present invention. According to some embodiments, the size of a first side of the aforementioned at least one via plug (e.g. one or more via plugs, such as the via plugs 401) is not less than 1 micrometer, and the size of a second side of the aforementioned at least one via plug (e.g. one or more via plugs, such as the via plugs 401) is not less than 3 micrometers. For example, each of the via plugs 401 may be implemented to have a conduction area such as 1 micrometer by 3 micrometers, to allow currents to pass through the via plugs 401 (e.g. from the metal pad 402 to the first specific metal layer routing 404, or from the first specific metal layer routing 404 to the metal pad 402) without damaging the via plugs 401.

According to some embodiments, as the multiple via plugs such as the via plugs 401 are implemented directly under the metal pad 402, some implementation parameters regarding the terminal lines may be kept constant, no matter whether the terminal lines are under the metal pad 402 or not. Examples of these implementation parameters regarding the terminal lines may include, but not limited to, the width of the terminal lines, the width of the gap between adjacent sets of terminal lines, and the width of the gap between the terminal lines in each set of terminal lines.

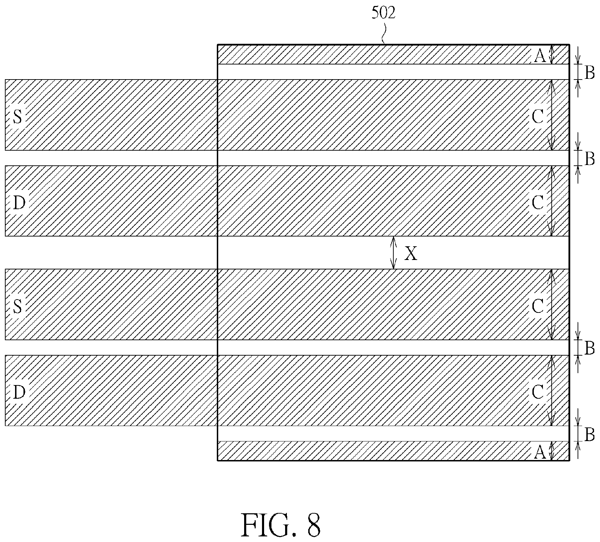

FIG. 8 is a simplified top-view diagram of a semiconductor device according to a fourth exemplary embodiment of the present invention, where the semiconductor device of this embodiment can be taken as an example of the semiconductor device 400 shown in FIG. 7, and the metal pad 502 can be taken as an example of the metal pad 402 described above. For brevity, the number of sets of terminal lines under the metal pad 502 may be two as illustrated in FIG. 7. Please note that the above embodiment is only for an illustrative purpose and is not meant to be a limitation of the present invention.

According to this embodiment, the terminal lines S can be taken as an example of the source terminal line corresponding to the source terminal of one of the FETs, and the terminal lines D can be taken as an example of the drain terminal line corresponding to the drain terminal of one of the FETs. Please note that the width C of the terminal lines, the width X of the gap between adjacent sets of terminal lines, and the width B of the gap between the terminal lines in each set of terminal lines may be kept constant, no matter whether the terminal lines are under the metal pad 502 or not. In addition, the first specific metal layer routing 404 of this embodiment may comprise at least one unused metal line (e.g. one or more unused metal lines) such as the two unused metal lines having the width A. For example, the aforementioned at least one unused metal line such as the two unused metal lines may be kept as a dummy pattern for robust bondability. For brevity, similar descriptions for this embodiment are not repeated in detail here.

Those skilled in the art will readily observe that numerous modifications and alterations of the device may be made while retaining the teachings of the invention. Accordingly, the above disclosure should be construed as limited only by the appended claims.

## Claims

1. A semiconductor device (400), comprising:
a metal pad (402), directly contacting a first metal layer (406) of the semiconductor device (400); and
a first specific metal layer routing (404), formed in a second metal layer (408) of the semiconductor device (400) and under the metal pad (402),
**characterized by** comprising:
the metal pad (402), positioned in the first metal layer (406); and
at least one via plug (401) for connecting the first specific metal layer routing (404) to at least one metal region in the first metal layer (406), wherein the via plug (401) is formed directly under the metal pad (402).

2. The semiconductor device (400) of claim 1, **characterized in that** the metal pad (402) has a thickness smaller than 20KA.

3. The semiconductor device (400) of claim 1, **characterized in that** material of the metal pad (402) is aluminum.

4. The semiconductor device (400) of claim 1, **characterized in that** the first specific metal layer routing has a uniform pattern (406).

5. The semiconductor device (400) of claim 4, **characterized in that** the uniform pattern has a metal density range between 30% and 70%.

6. The semiconductor device (400) of claim 1, **characterized in that** the first specific metal layer routing (404) comprises a plurality of sets of terminal lines (410-1, 414-1, 410-2, 414-2) corresponding to terminals of a plurality of field effect transistors, hereinafter FETs, respectively.

7. The semiconductor device (400) of claim 6, **characterized in that** there are oxide regions between the plurality of sets of terminal lines, and each oxide region has a width greater than 2 micrometers.

8. The semiconductor device (400) of claim 6, **characterized in that** a set of terminal lines within the plurality of sets of terminal lines comprises a source terminal line and a drain terminal line respectively corresponding to a source terminal and a drain terminal of a FET within the plurality of FETs.

9. The semiconductor device (400) of claim 8, **characterized in that** there is an oxide region between the source terminal line and the drain terminal line, and the oxide region has a width greater than 2 micrometers.

10. The semiconductor device (400) of claim 1, **characterized in that** the semiconductor device (400) further comprises:
a second specific metal layer routing (405), formed on the second metal layer (408) of the semiconductor device (400) and connected to the first specific metal layer routing (404), wherein the second specific metal layer routing (405) is not directly positioned under the metal pad (402).

11. The semiconductor device (400) of claim 10, **characterized in that** the first specific metal layer routing (404) comprises a plurality of sets of terminal lines (410-1, 414-1, 410-2, 414-2) corresponding to terminals of a plurality of FETs, respectively; and the second specific metal layer routing (405) comprises a plurality of sets of terminal lines (420-1, 424-1, 420-2, 424-2, 430-1, 434-1, 430-2, 434-2) corresponding to the plurality of sets of terminal lines (410-1, 414-1, 410-2, 414-2) of the first specific metal layer routing (404), respectively.

12. The semiconductor device (400) of claim 11, **characterized in that** the plurality of sets of terminal lines (420-1, 424-1, 420-2, 424-2, 430-1, 434-1, 430-2, 434-2) of the second specific metal layer routing (405) are extensions of the plurality of sets of terminal lines (410-1, 414-1, 410-2, 414-2) of the first specific metal layer routing (404), respectively.

13. The semiconductor device (400) of claim 1, **characterized in that** the first metal layer (406) and the second metal layer (408) are adjacent metal layers of the semiconductor device (400).

14. The semiconductor device (400) of claim 1, **characterized in that** at least one size of at least one side of the at least one via plug (401) is not less than 1 micrometer.

15. The semiconductor device (400) of claim 14, **characterized in that** a size of a first side of the at least one via plug (401) is not less than 1 micrometer, and a size of a second side of the at least one via plug is not less than 3 micrometers.

## Patentansprüche

1. Halbleitervorrichtung (400), umfassend:
ein Metallpad (402), das eine erste Metallschicht (406) der Halbleitervorrichtung (400) direkt kontaktiert; und
eine erste spezifische Metallschichtführung (404), die in einer zweiten Metallschicht (408) der Halbleitervorrichtung (400) und unter dem Metallpad (402) gebildet ist,
**gekennzeichnet durch**:
das Metallpad (402), das in der ersten Metallschicht (406) positioniert ist; und
zumindest einen Durchkontaktierungsstecker (401) zum Verbinden der ersten spezifischen Metallschichtführung (404) mit zumindest einem Metallbereich in der ersten Metallschicht (406), wobei der Durchkontaktierungsstecker (401) direkt unter dem Metallpad (402) ausgebildet ist.

2. Halbleitervorrichtung (400) nach Anspruch 1, **dadurch gekennzeichnet, dass** das Metallpad (402) eine geringere Dicke als 20KA aufweist.

3. Halbleitervorrichtung (400) nach Anspruch 1, **dadurch gekennzeichnet, dass** das Material des Metallpads (402) Aluminium ist.

4. Halbleitervorrichtung (400) nach Anspruch 1, **dadurch gekennzeichnet, dass** die erste spezifische Metallschichtführung ein gleichmäßiges Muster (406) aufweist.

5. Halbleitervorrichtung (400) nach Anspruch 4, **dadurch gekennzeichnet, dass** das gleichmäßige Muster einen Metalldichtebereich zwischen 30 % und 70 % aufweist.

6. Halbleitervorrichtung (400) nach Anspruch 1, **dadurch gekennzeichnet, dass** die erste spezifische Metallschichtführung (404) eine Vielzahl von Sätzen von Anschlussleitungen (410-1, 414-1, 410-2, 414-2) umfasst, die Anschlüssen einer Vielzahl von Feldeffekttransistoren, im Folgenden FETs bezeichnet, entsprechen.

7. Halbleitervorrichtung (400) nach Anspruch 6, **dadurch gekennzeichnet, dass** sich Oxidbereiche zwischen der Vielzahl von Sätzen von Anschlussleitungen befinden, und jeder Oxidbereich eine größere Breite als 2 Mikrometern aufweist.

8. Halbleitervorrichtung (400) nach Anspruch 6, **dadurch gekennzeichnet, dass** ein Satz von Anschlussleitungen innerhalb der Vielzahl der Sätze von Anschlussleitungen eine Source-Anschlussleitung und eine Drain-Anschlussleitung umfasst, die jeweils einem Source-Anschluss und einem Drain-Anschluss eines FET innerhalb der Vielzahl von FETs entsprechen.

9. Halbleitervorrichtung (400) nach Anspruch 8, **dadurch gekennzeichnet, dass** sich zwischen der Source-Anschlussleitung und der Drain-Anschlussleitung ein Oxidbereich befindet und der Oxidbereich eine größere Breite als 2 Mikrometer aufweist.

10. Halbleitervorrichtung (400) nach Anspruch 1, **dadurch gekennzeichnet, dass** die Halbleitervorrichtung (400) ferner umfasst:
eine zweite spezifische Metallschichtführung (405), die auf der zweiten Metallschicht (408) der Halbleitervorrichtung (400) ausgebildet ist und mit der ersten spezifischen Metallschichtführung (404) verbunden ist,
wobei die zweite spezifische Metallschichtführung (405) nicht direkt unter dem Metallpad (402) positioniert ist.

11. Halbleitervorrichtung (400) nach Anspruch 10, **dadurch gekennzeichnet, dass** die erste spezifische Metallschichtführung (404) eine Vielzahl von Sätzen von Anschlussleitungen (410-1, 414-1, 410-2, 414-2) umfasst, die jeweils den Anschlüssen einer Vielzahl von FETs entsprechen; und die zweite spezifische Metallschichtführung (405) eine Vielzahl von Sätzen von Anschlussleitungen (420-1, 424-1, 420-2, 424-2, 430-1, 434-1, 430-2, 434-2) umfasst, die der Vielzahl von Sätzen von Anschlussleitungen (410-1, 414-1, 410-2, 414-2) der ersten spezifischen Metallschichtführung (404) entsprechen.

12. Halbleitervorrichtung (400) nach Anspruch 11, **dadurch gekennzeichnet, dass** die Vielzahl der Sätze von Anschlussleitungen (420-1, 424-1, 420-2, 424-2, 430-1, 434-1, 430-2, 434-2) der zweiten spezifischen Metallschichtführung (405) jeweils Erweiterungen der Vielzahl von Sätzen von Anschlussleitungen (410-1, 414-1, 410-2, 414-2) der ersten spezifischen Metallschichtführung (404) sind.

13. Halbleitervorrichtung (400) nach Anspruch 1, **dadurch gekennzeichnet, dass** die erste Metallschicht (406) und die zweite Metallschicht (408) benachbarte Metallschichten der Halbleitervorrichtung (400) sind.

14. Halbleitervorrichtung (400) nach Anspruch 1, **dadurch gekennzeichnet, dass** zumindest eine Größe von zumindest einer Seite des zumindest einen Durchkontaktierungssteckers (401) nicht weniger als 1 Mikrometer beträgt.

15. Halbleitervorrichtung (400) nach Anspruch 14, **dadurch gekennzeichnet, dass** eine Größe einer ersten Seite des zumindest einen Durchkontaktierungssteckers (401) nicht kleiner als 1 Mikrometer ist, und eine Größe einer zweiten Seite des zumindest einen Durchkontaktierungssteckers nicht weniger als 3 Mikrometer beträgt.

## Revendications

1. Dispositif à semi-conducteur (400), comprenant :
un plot métallique (402), venant en contact direct avec une première couche métallique (406) du dispositif à semi-conducteur (400) ; et
un premier routage de couche métallique spécifique (404), formé dans une deuxième couche métallique (408) du dispositif à semi-conducteur (400) et sous le plot métallique (402),
**caractérisé en ce qu'**il comprend :
le plot métallique (402), positionné dans la première couche métallique (406) ; et
au moins une fiche traversante (401) pour relier le premier routage de couche métallique spécifique (404) à au moins une région métallique dans la première couche métallique (406), où la fiche traversante (401) est formée directement sous le plot métallique (402).

2. Dispositif à semi-conducteur (400) de la revendication 1, **caractérisé en ce que** le plot métallique (402) a une épaisseur inférieure à 20 KA.

3. Dispositif à semi-conducteur (400) de la revendication 1, **caractérisé en ce que** le matériau du plot métallique (402) est de l'aluminium.

4. Dispositif à semi-conducteur (400) de la revendication 1, **caractérisé en ce que** le premier routage de couche métallique spécifique présente un motif uniforme (406).

5. Dispositif à semi-conducteur (400) de la revendication 4, **caractérisé en ce que** le motif uniforme a une plage de densité métallique comprise entre 30% et 70%.

6. Dispositif à semi-conducteur (400) de la revendication 1, **caractérisé en ce que** le premier routage de couche métallique spécifique (404) comprend une pluralité d'ensembles de lignes de bornes (410-1, 414-1, 410-2, 414-2) correspondant aux bornes d'une pluralité de transistors à effet de champ, désignés ci-après par FET, respectivement.

7. Dispositif à semi-conducteur (400) de la revendication 6, **caractérisé en ce que** des régions d'oxyde se trouvent entre la pluralité d'ensembles de lignes de bornes, et chaque région d'oxyde a une largeur supérieure à 2 micromètres.

8. Dispositif à semi-conducteur (400) de la revendication 6, **caractérisé en ce qu'**un ensemble de lignes de bornes parmi la pluralité d'ensembles de lignes de bornes comprend une ligne de borne de source et une ligne de borne de drain correspondant respectivement à une borne de source et à une borne de drain d'un FET parmi la pluralité de FET.

9. Dispositif à semi-conducteur (400) de la revendication 8, **caractérisé en ce qu'**une région d'oxyde se trouve entre la ligne de borne de source et la ligne de borne de drain, et la région d'oxyde a une largeur supérieure à 2 micromètres.

10. Dispositif à semi-conducteur (400) de la revendication 1, **caractérisé en ce que** le dispositif à semi-conducteur (400) comprend en outre :
un deuxième routage de couche métallique spécifique (405), formé sur la deuxième couche métallique (408) du dispositif à semi-conducteur (400) et relié au premier routage de couche métallique spécifique (404), où le deuxième routage de couche métallique spécifique (405) n'est pas positionné directement sous le plot métallique (402).

11. Dispositif à semi-conducteur (400) de la revendication 10, **caractérisé en ce que** le premier routage de couche métallique spécifique (404) comprend une pluralité d'ensembles de lignes de bornes (410-1, 414-1, 410-2, 414-2) correspondant aux bornes d'une pluralité de FET, respectivement ; et le deuxième routage de couche métallique spécifique (405) comprend une pluralité d'ensembles de lignes de bornes (420-1, 424-1, 420-2, 424-2, 430-1, 434-1, 430-2, 434-2) correspondant à la pluralité d'ensembles de lignes de bornes (410-1, 414-1, 410-2, 414-2) du premier routage de couche métallique spécifique (404), respectivement.

12. Dispositif à semi-conducteur (400) de la revendication 11, **caractérisé en ce que** la pluralité d'ensembles de lignes de bornes (420-1, 424-1, 420-2, 424-2, 430-1, 434-1, 430-2, 434-2) du deuxième routage de couche métallique spécifique (405) sont des extensions de la pluralité d'ensembles de lignes de bornes (410-1, 414-1, 410-2, 414-2) du premier routage de couche métallique spécifique (404), respectivement.

13. Dispositif à semi-conducteur (400) de la revendication 1, **caractérisé en ce que** la première couche métallique (406) et la deuxième couche métallique (408) sont des couches métalliques adjacentes du dispositif à semi-conducteur (400).

14. Dispositif à semi-conducteur (400) de la revendication 1, **caractérisé en ce qu'**au moins une taille d'au moins un côté de l'au moins une fiche traversante (401) n'est pas inférieure à 1 micromètre.

15. Dispositif à semi-conducteur (400) de la revendication 14, **caractérisé en ce que** qu'une taille d'un premier côté de l'au moins une fiche traversante (401) n'est pas inférieure à 1 micromètre, et une taille d'un deuxième côté de l'au moins une fiche traversante n'est pas inférieure à 3 micromètres.
